# EUROPEAN PATENT SPECIFICATION

(11) **EP 3 582 233 B1**
(45) Date of publication and mention of the grant of the patent: **28.07.2021**
(21) Application number: 18382418.4
(22) Date of filing: 13.06.2018
(51) Int. Cl.: H01B 1/08, H01B 1/02, B41J 2/25, H05K 1/00, B29C 70/88, B41J 2/04, H05K 1/02, H05K 3/14

(54) **METHOD FOR PRINTED CABLE INSTALLATION IN HARNESS SYSTEMS FOR AIRCRAFTS AND A COMPOSITE ELEMENT WITH AN INTEGRATED HARNESS SYSTEM**
VERFAHREN ZUR GEDRUCKTEN KABELINSTALLATION IN KABELBAUMSYSTEMEN FÜR FLUGZEUGE UND VERBUNDELEMENT MIT INTEGRIERTEM KABELBAUMSYSTEM
PROCÉDÉ D'INSTALLATION DE CÂBLE IMPRIMÉ DANS DES SYSTÈMES DE HARNAIS POUR AÉRONEFS ET ÉLÉMENT COMPOSITE AVEC UN SYSTÈME DE HARNAIS INTÉGRÉ

(43) Date of publication of application: 18.12.2019
(73) Proprietor: Airbus Operations, S.L.U., 28906 Getafe (Madrid) (ES); Airbus Operations S.A.S., 31060 Toulouse (FR); Airbus Operations GmbH, 21129 Hamburg (DE)
(72) Inventor: SANCHEZ-GOMEZ, Jose, 28906 Getafe (Madrid) (ES); BLANCO VARELA, Tamara, 28906 Getafe (Madrid) (ES); BRITO MAUR, Cristobal Federico, 21129 Hamburg (DE); RODEGHIERO, Alain, 31060 Toulouse (FR)
(74) Representative: Herrero & Asociados, S.L.

(56) References cited:
- EP-A1- 1 127 387
- EP-A1- 3 216 690
- EP-A1- 3 284 680
- EP-A1- 3 296 092
- WO-A1-95/11129
- WO-A1-2018/041321
- GB-A- 2 517 465
- US-A1- 2012 051 701
- US-B1- 7 277 266

## Description

### Technical field of the invention

The present invention relates to a method for cable installation that prints conductive traces to a surface of an aircraft to complete an electrical circuit of a harness system and a composite element for an aircraft with an integrated harness system.

### Background of the invention

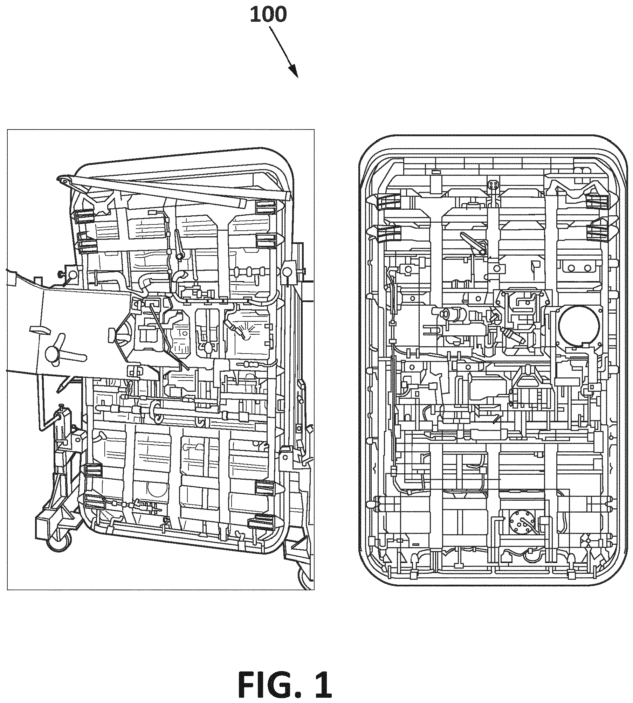

Traditionally, cables are routed throughout an aircraft and in particularly through the aircraft fuselage using cable routing harnesses which are substantially inflexible structural members for assembly of cables, either coaxial cables and twisted pair cables. Installing a harness system comprising a large number of cables and several individual harnesses is a costly and hard-working process and wherein part drilling and screwing actions have to be performed. Hence, the current installation processes for harness systems can be very time consuming, especially when dealing with complex locations, e.g. a harness system for a door of an aircraft comprises 24 cables to be assembled on the door of the aircraft as shown in figure 1.

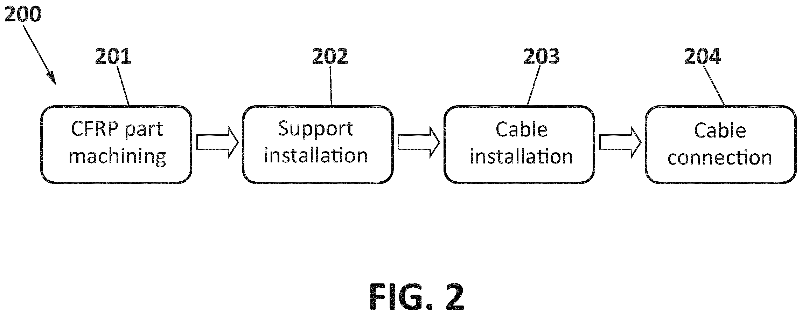

Currently, every harness cable installation must go through a support installation process that involves part drilling, screwing, and/or adhesion techniques previous to cable installation and cable connection processes as shown in figure 2. Harness cable installation can be a costly procedure with a requirement of an accurate process control to avoid compromising the system quality and performance. Furthermore, conventional cable installation procedures increase lead time, material costs and imply human-sourced defects.

Therefore, a method for cable installation in harness systems that simplifies the current cable installation methods and solves the aforementioned drawbacks is desired.

EP3216690A1 relates to a method for manufacturing a lining panel with integrated electric lines for a lining of a passenger cabin of an aircraft or spacecraft. The method comprise using (M3) an additive manufacturing, AM, or 3D printing technique to form the electric lines on or into a panel body of the lining panel. The present invention further pertains to a lining panel with integrated electric lines for a lining of a passenger cabin of an aircraft or spacecraft. The lining panel comprises a panel body and electric lines being formed on or into the panel body using an AM or 3D printing technique.

### Description of the invention

With the proposed method for cable installation in harness systems for aircrafts it is possible to simplify the current harness cable installation processes by at least avoiding the support installation process previous to cable installation and cable connections processes. Hence, in one aspect, the present invention refers to a method for printed cable installation in harness system that comprises printing a predetermined number of pairs of independent conductive traces on a surface or any other structure of the fuselage of an aircraft, sintering the pairs of independent conductive traces by means of a laser, and interposing an insulating film between the pairs of independent conductive traces The electromagnetic compatibility between pairs of independent conductive traces is equivalent to the one achieved by twisted pairs used in conventional harness systems. Hence, the pairs comprise a trace length less than 5 meters and the traces are printed with a guard trace to reduce crosstalk. Typically, guard traces are grounded at both ends.

A second aspect of the invention is an integrated harness system having a printed cable installation obtained with the method for printed cable installation according to the present invention.

A third aspect of the invention is a composite element for an aircraft with an integrated harness system according to the present invention.. The harness system is obtained by printing a predetermined number of pairs of conductive traces on a surface of the composite element with a printing technology for printed electronics. The printing technology permits applying metallic printed paths on composite element of the aircraft. Printed technologies for electronics can create electrical devices on various substrates and imply low cost processes. Examples of printing technologies used according to the present invention are ink-based technologies, e.g. ink-jet printing as aerosol jet and powder-based technology, e.g. gas dynamic cold spray (CS). Copper, as well as other conductors, fit well the electrical capabilities of the printed cables with a maximum linear resistance of 34Ω/km.

The aforementioned printing technologies provide adhesion stability to avoid the peel off of the metallic printed paths. Furthermore, the applied printed paths achieve the correct thickness to support the electrical requirements of the system, mainly, current and linear electrical resistance.

In one example according to the present disclosure, a door of an aircraft comprises the composite element and wherein the metallic printed paths are printed on the Carbon Fiber Reinforced Polymer Frame (hereinafter CFRP) door surface based on any of the aforementioned techniques. In another example, according to the present disclosure a fuselage section of an aircraft comprises the composite element.

With the proposed method, the support installation process is no longer needed resulting in material cost expenditure avoidances. Furthermore, the proposed method is an automatic process that avoids human-sourced defects, reduces manufacturing steps and maintenance. Furthermore, the proposed method helps to save time, cost and resources. Additionally, electronic printing allows a reduction of the installation duration; thus, a reduced lead time is possible and related resources are saved. Since the conductive traces or metallic paths are automatically printed, a multifunctional modularization is possible, so consequently the assembly efforts can be reduced. Furthermore, the amount of solid parts compared to conventional systems is decreased with a corresponding weight reduction, and therefore the available space increases.

### Brief description of the drawings

For a better understanding the above explanation and for the sole purpose of providing an example, some non-limiting drawings are included that schematically depict a practical embodiment.
Figure 1 shows a conventional harness system of a door of an aircraft.
Figure 2 shows a block diagram for a conventional cable installation process.
Figure 3 shows a first block diagram for printed cable installation on a harness system according to the present disclosure using aerosol jet as printing technology.
Figure 4 shows a second block diagram for printed cable installation on a harness system according to the present disclosure using cold spray as printing technology.

### Preferred embodiment of the invention

Figure 1 shows a conventional harness system 100 of a door of an aircraft. As previously mentioned, in some aircrafts a harness system can comprises 24 cables fulfilling bonding, grounding, power and analogue functions that have to be assembled on the door of the aircraft. This assembly is complex, costly and subjected to maintenance and aging.

Figure 2 shows a block diagram 200 for a conventional cable installation process. The block diagram 200 comprises block 201 for machining the CFRP surface so that said CFRP surface is cut into a desired final shape and size by a controlled material-removal process. The block diagram 200 comprises block 202 for support installation that can involve several steps as drilling/screwing and/or adhesion techniques involving a costly procedure with need of accurate process control in order to avoid compromising the system quality and performance. Furthermore, the block diagram 200 comprises block 203 for cable installation and block 204 for cable connection.

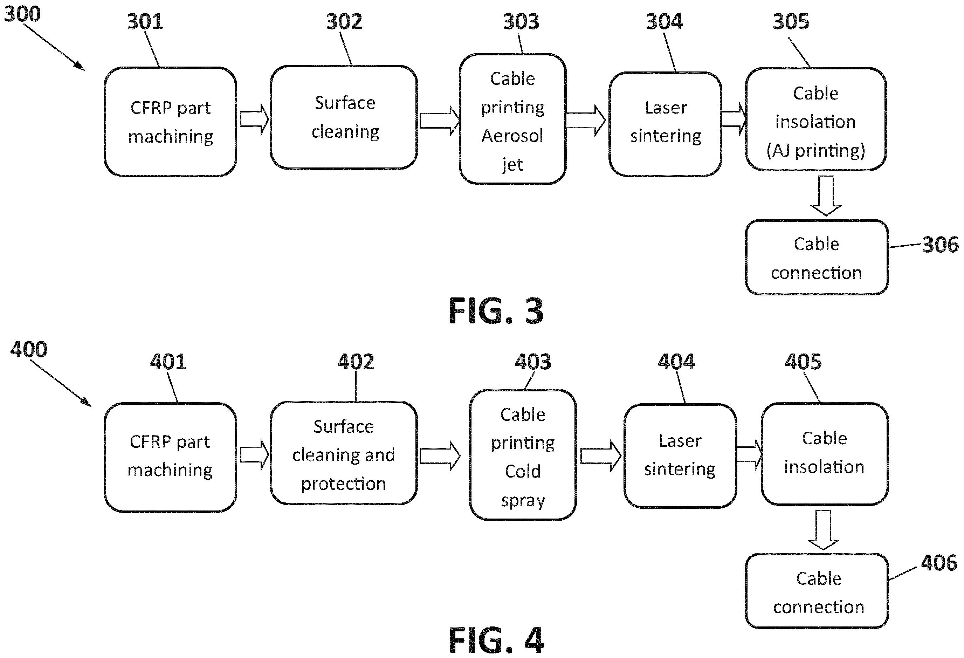

Figure 3 shows a block diagram 300 for printed cable installation in a harness system for a CFRP surface of a fuselage of an aircraft. The conductive traces are printed using aerosol jet as printing technology. The block diagram 300 comprises block 301 for machining the CFRP surface so that said CFRP surface is cut into a desired final shape and size by a controlled material-removal process. The block diagram 300 further comprises block 302 for cleaning the CFRP surface. The block diagram 300 further comprises block 303 for printing pairs of metallic paths on the CFRP surface by using aerosol jet.

The block diagram 300 further comprises block 304 for laser sintering to sinter the powder material comprised in the metallic paths. Sintering is the process of compacting and forming a solid mass of conductive material from the conductive powder comprised in the metallic printed paths. Sintering can be performed by applying heat with a laser without melting it to the point of liquefaction.

The block diagram 300 further comprises block 305 for cable isolation between pairs of metallic printed paths. In order to achieve the correct electrical conductivity, and consequently, a minimum electrical linear resistance and eliminate crosstalk, an insulating film between pairs of metallic paths is interposed. The insulating film provides shielding and protection between said pairs of metallic paths.

The block diagram 300 further comprises block 306 for completing the electrical circuit after applying a predetermined number of pairs of metallic paths as part of the harness system by connecting a voltage source, a load, etc. In an example, the harness system is built for a door of an aircraft that comprises 192 metallic printed paths grouped in 96 pairs corresponding to 24 twisted cables.

Fig. 4 shows a block diagram 400 for printed cable installation in a harness system for a CFRP surface of a fuselage of an aircraft. The metallic paths are printed using cold spray as printing technology. The block diagram 400 comprises block 401 for machining the CFRP surface. The block diagram 400 further comprises block 402 for cleaning and protecting the CFRP surface. The block diagram 400 further comprises block 403 for printing pairs of metallic paths on the CFRP surface by using cold spray.

The block diagram 400 further comprises block 404 for laser sintering to sinter the powder material comprised in the metallic paths. The block diagram 400 further comprises block 405 for cable isolation between pairs of metallic printed paths to achieve the electrical benefits of the twisted pair cable and obtain a minimum electrical linear resistance. The block diagram 400 further comprises block 406 for completing the electrical circuit after applying a predetermined number of pairs of conductive metallic paths required for the harness system.

Even though reference has been made to a specific embodiment of the invention, it is obvious for a person skilled in the art that the lightning protector described herein is susceptible to numerous variations and modifications, and that all the details mentioned can be substituted for other technically equivalent ones without departing from the scope of protection defined by the attached claims.

## Claims

1. A method for printed cable installation in a harness system of an aircraft, the method comprising:
printing (303, 403) at least a first conductive trace comprising conductive particles to a surface of an aircraft with a printing technology;
printing (303, 403) at least second conductive trace comprising conductive particles to the surface of an aircraft with the printing technology,
sintering (304, 404) the first and the second conductive traces by means of a laser;
interposing (305, 405) an insulating film between the first and the second conductive traces,
wherein the first and second conductive traces comprise a trace length less than 5 meters, and
wherein the first and second conductive traces are printed with a guard trace.

2. The method of claim 2, further comprising cleaning (302) the surface of an aircraft before printing the first and second conductive traces.

3. The method of claims 1 to 2, wherein the printing technology consists of ink-based printing.

4. The method of claim 3, wherein the ink-based printing technology consists of aerosol jet.

5. The method of claims 1 to 2, wherein the printing technology consists of powder-based printing.

6. The method of claim 5, wherein the powder-based printing technology consists of cold spray.

7. The method according to claims 1 to 6, comprises using copper as conductor for the printing technology.

8. An integrated harness system having a printed cable installation obtained according to the method claims 1 to 7.

9. A composite element comprising the integrated harness system according to claim 8.

10. A fuselage section comprising the composite element of claim 9

11. A door of an aircraft comprising the composite element of claim 9.

## Patentansprüche

1. Verfahren für eine gedruckte Kabelinstallation in einem Kabelbaumsystem eines Flugzeugs, mit:
Drucken (303, 403) mindestens einer ersten leitfähigen Spur mit leitfähigen Partikeln auf eine Oberfläche eines Flugzeugs mit einer Drucktechnologie;
Drucken (303, 403) mindestens einer zweiten leitfähigen Spur mit leitfähigen Partikeln auf die Oberfläche eines Flugzeugs mit der Drucktechnologie;
Sintern (304, 404) der ersten und der zweiten leitfähigen Spur mit Hilfe eines Lasers;
Einfügen (305, 405) einer Isolierschicht zwischen der ersten und der zweiten leitfähigen Spur,
wobei die erste und die zweite leitfähige Spur eine Spurlänge von weniger als 5 Metern aufweisen, und
wobei die erste und die zweite leitfähige Spur mit einer Schutzspur gedruckt werden.

2. Verfahren nach Anspruch 1, ferner mit Reinigen (302) der Oberfläche eines Flugzeugs vor dem Drucken der ersten und zweiten leitfähigen Spur.

3. Verfahren nach Anspruch 1 oder 2, wobei die Drucktechnologie aus tintenbasiertem Drucken besteht.

4. Verfahren nach Anspruch 3, wobei die Drucktechnologie aus Aerosol-Jet besteht.

5. Verfahren nach Anspruch 1 oder 2, wobei die Drucktechnologie aus pulverbasiertem Drucken besteht.

6. Verfahren nach Anspruch 5, wobei die Drucktechnologie aus Kaltspritzen besteht.

7. Verfahren nach einem der Ansprüche 1 bis 6, umfassend die Verwendung von Kupfer als Leiter für die Drucktechnologie.

8. Integriertes Kabelbaumsystem mit einer gedruckten Kabelinstallation, erhalten nach den Verfahrensansprüchen 1 bis 7.

9. Verbundelement mit dem integrierten Kabelbaumsystem nach Anspruch 8.

10. Rumpfbereich mit dem Verbundelement nach Anspruch 9.

11. Tür eines Flugzeugs mit dem Verbundelement nach Anspruch 9.

## Revendications

1. Procédé pour l'installation d'un câble imprimé dans un système de harnais d'un avion, le procédé comprenant les étapes suivantes :
imprimer (303, 403) au moins une première trace conductrice comprenant des particules conductrices sur une surface d'un avion avec une technologie d'impression ;
imprimer (303, 403) au moins une seconde trace conductrice comprenant des particules conductrices sur la surface d'un avion avec la technologie d'impression ;
fritter (304, 404) la première et la seconde trace conductrice au moyen d'un laser ;
intercaler (305, 405) un film isolant entre la première et la seconde trace conductrice,
dans lequel les première et seconde traces conductrices comprennent une longueur de trace inférieure à 5 mètres, et
dans lequel les première et seconde traces conductrices sont imprimées avec une trace de protection.

2. Procédé selon la revendication 1, comprenant en outre l'étape pour nettoyer (302) la surface d'un avion avant l'impression des première et seconde traces conductrices.

3. Procédé selon les revendications 1 à 2, dans lequel la technologie d'impression se compose d'une impression à base d'encre.

4. Procédé selon la revendication 3, dans lequel la technologie d'impression à base d'encre se compose d'un jet d'aérosol.

5. Procédé selon les revendications 1 à 2, dans lequel la technologie d'impression se compose de l'impression à base de poudre.

6. Procédé selon la revendication 5, dans lequel la technologie d'impression à base de poudre se compose d'une pulvérisation froide.

7. Procédé selon les revendications 1 à 6, comprenant l'utilisation de cuivre en tant qu'un conducteur pour la technologie d'impression.

8. Système de harnais intégré ayant une installation de câble imprimé obtenu selon le procédé selon les revendications 1 à 7.

9. Élément composite comprenant le système de harnais intégré selon la revendication 8.

10. Section de fuselage comprenant l'élément composite selon la revendication 9.

11. Porte d'un avion comprenant l'élément composite selon la revendication 9.
